(19) **Europäisches Patentamt**
**European Patent Office**
**Office européen des brevets**

(11) **EP 1 936 391 B1**

(12) **EUROPEAN PATENT SPECIFICATION**

(45) Date of publication and mention
of the grant of the patent:
**09.02.2011  Bulletin 2011/06**

(51) Int Cl.:
**G01R 19/32** *(2006.01)*     **G01R 21/14** *(2006.01)*

(21) Application number: **06466018.6**

(22) Date of filing: **19.12.2006**

(54) **Apparatus and method for improving the accuracy of instrument transformers**

Vorrichtung und Verfahren zur Präzisionserhöhung bei Messwandlern

Dispositif et procédé pour améliorer la précision de transformateurs de mesure

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**25.06.2008  Bulletin 2008/26**

(73) Proprietor: **ABB Technology AG**
**8050 Zürich (CH)**

(72) Inventors:
• **Javora, Radek**
**624 00 Brno (CZ)**

• **Kral, Petr**
**625 00 Brno (CZ)**

(74) Representative: **Kania, Frantisek**
**Kania Sedlak Smola,**
**Mendlovo Namesti 1 a**
**603 00 Brno (CZ)**

(56) References cited:
**WO-A-02/097454      US-A1- 2005 094 344**
**US-A1- 2005 156 587**

## Description

### Field of the invention

The invention concerns an apparatus and a method for improving the accuracy in measuring at least one electrical parameter, i.e. the voltage and/or the current, of an electrical conductor. The definition of "electrical conductor" it is hereby to be understood as encompassing any piece of electrical device through which an electrical power flows, such as but not limited to a power line, a cable internal or external to an electrical equipment, an electrical equipment itself, for instance circuit breakers, disconnectors, switches, and similar devices or apparatuses.

### Prior art

Electrical devices must have a safety device that switches off the equipment as soon as the voltage or current differs from a given value. It is important to switch off the device immediately after the voltage or current is too different from a critical value, but at the same time it is useful to avoid switching off too often, when the value is only nearing the critical value. To achieve this, the detection means used, such as electronic instrument transformers, must measure as precisely as they conveniently can the electrical parameters related to the device they are associated with.

The measurement is influenced by different factors or interferences when we consider these factors as detrimental. For instance, such factors include a temperature of the measuring unit or of the environment around it, cross-talk effects in the case of two or three phase configuration, influence of other external magnetic and/or electric fields, mutual influence between voltage and current sensors, transient phenomena resulting in a different frequency response on different frequencies etc.

Present electronic instrument transformers suffer from low accuracy, hardly better than 0.5 % under the worst conditions, and thus they are not optimally suitable for applications where a higher accuracy is required.

This is especially important in case of electronic instrument transformers that have much lower voltage and/or current outputs than for example inductive instrument transformers. The interferences have in case of electronic instrument transformers a bigger impact than in case of inductive instrument transformers where, due to a big difference between the output signal of inductive instrument transformers and the interference signal, the influence of the interference signal could be practically neglected.

When the measuring unit measures a voltage or a current and its temperature is close to ambient temperature, its output value is different from the output value of the same measuring unit measuring the same voltage or current when its temperature is different from the surrounding ambient.

Similarly, in case of two- or three-phase configuration there can be a mutual factor (crosstalk) between two phases and a crosstalk signal superimposed on one phase can introduce a measurement error of the measuring unit.

In case of external magnetic and/or electric fields due to the presence of other close electrical devices, similar disturbances can be observed that again can introduce a measurement error of the measuring unit. The same applies in the presence of magnetic and/or electric fields internal to the measuring apparatus and due to interferences among the various components of the measuring elements, in particular when both current and voltage sensor means are used.

Yakymyshyn et al. disclose in US 2005/0156587 a current sensor that uses a plurality of magnetic field sensors positioned around a current carrying conductor. Magnetic field sensors have a sensitivity varying for example with the ambient temperature. A temperature sensor is used to measure the temperature so as to generate an error voltage that is proportional to temperature. In particular a signal processor, or digital look-up table, generates a voltage signal, i.e. the error voltage, which controls a voltage regulator which in turns generates the power supply voltage for all magnetic field sensors. Therefore, when the temperature varies, the error voltage applied to the magnetic field sensors varies thus modifying the sensitivity of the magnetic field sensors in order to take into account the influence of the disturbing temperature. The measurement of the electrical parameter is thus corrected at the input stage.

Veselin Skendzic et al. disclose in WO 02/097454 a measurement of the AC voltage applied to a primary high voltage conductor of a desired phase in a multi-phase system by using active electronic circuitry to compensate for crosstalk introduced by one or more additional phases in the multi-phase system. The voltage measurement may be based upon the use of a capacitive voltage sensor for each phase in the multi-phase system. A voltage measurement is obtained for the desired phase and for each additional phase in the multi-phase system. A product is generated for each additional phase by multiplying the additional phase voltage measurement by a corresponding predetermined constant. The product for each additional phase then is subtracted from the voltage measurement of the desired phase. In a three-phase system, outputs of three voltage sensors are amplified, corrections are made for gain and temperature variations, and the outputs are combined together to cancel the effects of mutual coupling between the three individual phases. Again, the measurement of the electrical parameter is corrected at the input stage.

### Subject matter of the invention

The above described disadvantages of the prior art are at least partly rectified by the apparatus and method of the present invention. In particular, the present invention provides an apparatus for measuring at least one electrical parameter of at least a first phase of an electrical conductor, comprising:

- an electronic unit;
- detecting means for providing said electronic unit with signals indicative of values of said at least one electrical parameter and of values of at least one disturbing factor influencing said signals indicative of the values of said at least one electrical parameter, said electronic unit calculating values of said at least one electrical parameter and of said at least one disturbing factor based on the provided signals;
- characterized in that it comprises a correction unit which is operatively coupled with said electronic unit and has a plurality of pre-stored corrective coefficients corresponding to values of said at least one disturbing factor, wherein said corrective coefficients are applied to the calculated values of said at least one electrical parameter based on the calculated values of said at least one disturbing factor.

The present invention also encompasses a method for measuring at least one electrical parameter of at least a first phase of an electrical conductor, comprising the following steps:

- providing signals indicative of values of said at least one electrical parameter and of values of at least one disturbing factor influencing said signals indicative of the values of said at least one electrical parameter;

  - calculating values of said at least one electrical parameter and of said at least one disturbing factor based on the provided signals;
  - characterized in that it further comprises correcting the values calculated for said at least one electrical parameter by applying to the calculated values of said at least one electrical parameter pre-stored corrective coefficients corresponding to values calculated for said at least one disturbing factor.

The apparatus according to the invention preferably comprises at least one electronic instrument transformer which is associated to a phase of an electrical conductor of which it is desired to accurately measure one or more electrical parameters, typically the voltage and/or the current. These parameters are typically the ones indicating the working conditions of the electrical conductor.

In a first exemplary embodiment, the apparatus according to the invention comprises a voltage divider which is preferably provided with a thermometer associated therewith The voltage output of the voltage divider is provided to an electronic unit, typically an intelligent electronic device (IED), such as a microprocessor-based relay. Also the output of the thermometer is provided to the electronic unit. A corrective unit is operatively coupled to the electronic unit for correcting an output signal thereof. Preferably, the corrective unit is part or component of the electronic unit itself and comprises one or more software modules. In particular, the corrective unit comprises a plurality of corrective coefficients which are conveniently pre-stored in a storing memory of the corrective unit itself or of other parts of the electronic unit. Such corrective coefficients correspond to different values of temperature stored in its memory, and are applied to the measured values of the voltage of the conductor phase.

In another exemplary embodiment of the present invention, the apparatus comprises a toroidal coil positioned around a phase of the electrical conductor to be measured. Also in this case, the toroidal coil is preferably provided with a thermometer, and the outputs of both the toroidal coil and the thermometer are provided to the electronic unit. Likewise, the calculated values of the current flowing through the phase are corrected by means of corrective temperature coefficients corresponding to the values of temperature calculated based on the detection of the thermometer.

In other embodiments the correction unit comprises sets of pre-stored corrective coefficients for correcting errors caused by other influencing factors, such as cross-talk effects for adding a corrective offset that is assigned to the measured value of the crosstalk to the measured value of the voltage and/or of the current of the measured phase conductor. In addition, the correction unit comprises also pre-stored sets of corrective coefficients which correspond to values of other disturbing factors, namely external and/or internal magnetic and/or electric fields, values of harmonics different from rated frequency of the electronic instrument transformer.

In particular, in the apparatus and method according to the invention, corrective coefficients corresponding to different disturbing factors can be applied at the same time to the calculated values of current and/or voltage.

### Brief description of the drawings

The invention will be further described in connection with its preferred embodiments and reference is made to the accompanying drawings wherein:

Fig. 1 is a schematic representation of a structure of measuring system with internal errors;
Fig. 2 is a schematic representation of a first embodiment of an electronic measuring apparatus correcting voltage errors caused by temperature fluctuations;
Fig. 3 is a schematic representation of a second embodiment of an electronic measuring apparatus correcting current errors caused by temperature fluctuations;
Fig. 4 is a schematic representation of a third embodiment of an electronic measuring apparatus correcting both voltage and current error caused by a temperature fluctuations;

Fig. 5 is an exemplary view of an electronic current transformer containing a thermometer;

Fig. 6 is an exemplary view of an electronic voltage transformer containing a thermometer;

Fig. 7 is an exemplary views of a combined current and voltage transformer with a thermometer;

Fig. 8-10 are schematic views corresponding to Figs. 5-7, respectively;

Fig. 11 is an exemplary flow diagram representing the method according to the invention.

## Description of preferred embodiments

It should be noted that in order to clearly and concisely disclose the present invention, the drawings may not necessarily be to scale and certain features of the invention may be shown in somewhat schematic form. Further, like parts bear similar reference numerals.

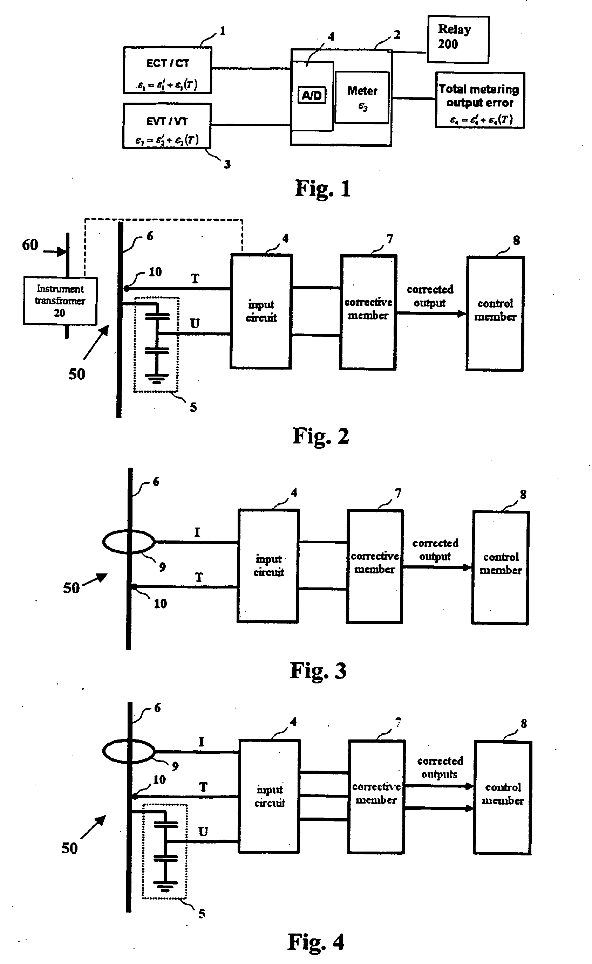

Generally, a principle of a measuring apparatus can be described according to Fig. 1. A current transformer **1,** either electronic or inductive, is connected to a current measurement input of an electronic relay **2,** while a voltage transformer **3,** either electronic or inductive, is connected to a voltage measurement input of the same electronic relay **2.** Current and/or voltage values are the electrical parameters whose signals carry information about the working conditions of the electrical component which is subject to measurements. Both voltage and current measurement inputs are connected to an A/D converter of the electronic relay **2,** said A/D converter being an input circuit **4** of the electronic relay **2.** The outputs of the input circuit **4** are connected to a meter, at the outputs of which are the measured values.

When we consider as the interference only a temperature T, the error of the current transformer **1** could be expressed as

$$\varepsilon_1 = \varepsilon'_1 + \varepsilon_1(T),$$

where $\varepsilon_1$ is a total error of the current transformer **1,** $\varepsilon'_1$ is an inherent error of the current transformer **1,** and $\varepsilon_1(T)$ is an error caused by temperature changes.

Similarly, the error of the voltage transformer **3** could be expressed as

$$\varepsilon_2 = \varepsilon'_2 + \varepsilon_2(T),$$

where $\varepsilon_2$ is a total error of the voltage transformer **3** $\varepsilon'_2$ is an inherent error of the voltage transformer **3** and $\varepsilon_2(T)$ is an error caused by temperature changes.

If we consider an error of the meter to be $\varepsilon_3$, then the total error $\varepsilon_4$ of the whole system would be

$$\varepsilon_4 = \varepsilon_1 + \varepsilon_2 + \varepsilon_3.$$

The main aim of an electronic measuring apparatus is to eliminate the influence of this disturbing factor, that is of the temperature, and to achieve the total error $\varepsilon'_4$ of the whole system to be

$$\varepsilon'_4 = \varepsilon_1 + \varepsilon_2 + (\varepsilon_3 - \varepsilon_1(T) - \varepsilon_2(T)).$$

The same considerations apply when considering other disturbing factors or interferences, affecting the accuracy of measurements.

This aim could be achieved by different embodiments of an electronic measuring apparatus and the method according to the invention.

Likewise, to provide an electronic measuring apparatus with eliminated errors caused by other different factors it is necessary to measure directly or indirectly the influence of individual factors on a measurement error. Thus, for eliminating a crosstalk error an interference current and/or voltage on one phase caused by different currents and/or voltages on neighboring phases must be measured, the results must be entered into a memory of the corrective unit **7** in a form of coefficients, by which the measuring results should be corrected for eliminating the crosstalks error. The corrective unit **7** thus can, having information about instantaneous values of currents and voltages on neighboring phases, correct the measurement of current and voltage of the measured line **6** by eliminating the error caused by crosstalks.

Similarly, for eliminating an external magnetic and/or electric field that is given by an arrangement of the electronic measuring apparatus, a measurement of the magnetic and/or electric field in relation to the current and/or voltage on each individual phase must be measured and its influence on a measurement error must be determined. The results must be entered into a memory of the corrective unit **7** in a form of coefficients, by which the measuring results should be corrected for eliminating the external magnetic and/or electric field error. The corrective unit **7** thus can, having an information about instantaneous values of external magnetic and/or electric field, correct the measurement of current and/or voltage of the measured line **6** by eliminating the error caused by said external magnetic and/or electric field.

The internal magnetic and/or electric field appears in a combined electronic transformer, in which measurements of current and voltage influence each other. Again, a measurement of mutual influence must be conducted, the results entered into a memory of the corrective unit **7** so that the corrective unit **7** can, having an information about that mutual influence, correct the measurement of current and voltage of the measured line **6** by eliminating the error caused by said internal magnetic and/or electric field.

In case harmonics occur either in an electric power network or due to a frequency response of the electronic instrument transformer, the accuracy of measurement in the range of frequencies different from rated ones is worsened. This problem could be solved by a measurement of influence of said harmonics on the results of measurements of current and voltage of the measured line **6**. The results of the measurement of influence of said harmonics must be entered into a memory of the corrective unit **7,** so that the corrective unit **7** can, having an information about the influence of said harmonics on the results of measurements of current and voltage of the measured line **6,** correct the measurement of current and voltage of the measured line **6** by eliminating the error caused by said harmonics.

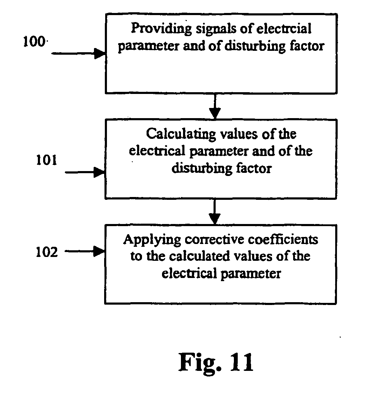

Figures 2-4 illustrate some embodiments of the apparatus according to the invention which is used to measure one or more electrical parameters of at least one phase of an electrical conductor, e.g. a power line, schematically indicated by the reference numeral **6**. The apparatus comprises an electronic unit **2** typically an intelligent electronic device (IED), such as a microprocessor-based relay, and detecting means, which are indicated in figures 2-4 by the overall reference number **50,** and preferably comprise at least one electronic instrument transformer. As shown in Fig. 11, in a first step **100** of the method according to the invention, the detecting means **50** provide the electronic unit **2** with signals indicative of values of at least one electrical parameter, i.e. the current and/or the voltage, of the measured line phase **6**. Further, they provide the electronic unit **2** with signals indicative of values of at least one disturbing factor influencing the signals indicative of the electrical parameters. Based on the provided signals, at step **101** the electronic unit **2** calculates values of the at least one electrical parameter and of the at least one disturbing factor considered.

Advantageously, the subject apparatus comprises a correction unit or member **7** which is operatively coupled with the electronic unit **2** and has a plurality of pre-stored corrective coefficients corresponding to values of the at least one disturbing factor considered. Preferably, the corrective unit **7** is part or component of the electronic unit **2** and comprises one or more software modules. At phase **102** corrective coefficients are applied to the calculated values of the at least one electrical parameter based on the calculated values of the at least one disturbing factor.

In a preferred embodiment, the corrective unit **7** comprises pre-stored corrective coefficients related to values of temperatures stored in its memory (or in any other memory unit part of the electronic unit **2**). These coefficients are applied to the measured value of the voltage and/or current of the conductor phase **6**.

In other embodiments the correcting unit **7** comprises sets of pre-stored corrective coefficients for correcting errors caused by other influencing factors, such as cross-talk effects for adding a corrective offset that is assigned to the measured value of the crosstalk to the measured value of the voltage and/or of the current of the measured phase conductor **6**. In addition, the correction unit comprises also pre-stored sets of corrective coefficients which correspond to values of other disturbing factors, namely external and/or internal magnetic and/or electric fields, values of harmonics different from rated frequencies, such as the rated frequency of the electronic instrument transformer used, or of the electrical network. The various sets of coefficients can be stored as discrete values corresponding to the specific disturbing factor values, or in form of curves.

As illustrated in Fig. 2, in the first embodiment of an electronic measuring apparatus conceived for correcting a voltage error caused by temperature fluctuations, there is a voltage transformer, preferably a voltage divider **5,** the first end of which is connected to the measured line **6** and the other end of which is earthed. The voltage divider **5** in this embodiment consists of two capacitances, but it can consist of any impedance, as resistors and others. In addition, at least one thermometer **10** is associated with the voltage divider **5**. The term thermometer it is to be understood as encompassing any means suitable to measure a temperature, such as one or more thermocouples. The low voltage output **U** of the voltage divider **5** is coupled with a measuring signal input of the input circuit **4** and the temperature output **T** of the thermometer **10** is coupled with a temperature signal input of the input circuit **4**. The input circuit **4** is typically an A/D converter. The measuring signal output of the input circuit **4** is then coupled with a measuring signal input of a corrective unit **7**. The temperature signal output of the input circuit **4** is then coupled with a temperature signal input of a corrective unit **7**. The output of the corrective unit **7** is then coupled to a control unit **8**.

In operation, the signal from the low voltage output **U** of the voltage divider **5** is proportional to the measured voltage of the measured line **6** and the temperature signal from the temperature output **T** of the thermometer **10** contains information about temperatures detected. Preferably, the thermometer **10** supplies information about temperatures of the voltage divider **5** or around it. Morse thermometers **10** may be used to give more information about the temperatures inside the apparatus, preferably at or close to the voltage divider **5**. The input circuit **4** modifies the measuring and temperature signals so that they match the circuitry of the corrective unit **7**. Typically the input circuit **4** is an A/D converter that digitalizes both the analog signal from the low voltage output **U** of the voltage divider **5** and the analog signal bearing information about the temperature from the temperature output **T** of the thermometer **10**. Adjusted signals from the input circuit **4** are then inputted to the inputs of the corrective unit **7**. The corrective unit **7** stores a succession of offset values corresponding to different values of temperature and is thus able to add a corrective offset assigned to the measured value of the temperature, to the measured value of the voltage of the measured phase **6.** Thus, a more correct and precise value of the voltage of the measured phase **6** is obtained.

In a second embodiment illustrated in. Fig. 3, the detecting means **50** comprise a current transformer, preferably a toroidal coil **9,** through which a measured line phase **6** passes. Also in this case, at least one thermometer **10** is coupled with the toroidal coil 9. The measuring signal output of the toroidal coil **9** is coupled to a measuring signal input of the input circuit **4** and the temperature signal output **T** of the thermometer **10** placed on or close to the toroidal coil **9** is coupled with a temperature signal input of the input circuit **4.** The input circuit **4** is typically an A/D converter. The measuring signal output of the input circuit **4** is then coupled with a measuring signal input of a corrective unit **7.** The temperature signal output of the input circuit **4** is then coupled with a temperature signal input of a corrective unit **7.** The output of the corrective unit **7** is then coupled to a control unit **8.**

In operation, the signal from the measuring signal output of the toroidal coil **9** is proportional to the measured current of the measured line **6** and the temperature signal from the temperature output **T** of the thermometer **10** contains information about the temperature of the toroidal coil **9.** The input circuit **4** modifies the measuring and temperature signals so that they match the circuitry of the corrective unit **7.** Typically the input circuit **4** is an A/D converter that digitalizes both the analog signal from the output of the toroidal coil **9** and the analog signal bearing information about temperature from the temperature output **T.** Adjusted signals from the input circuit **4** are then inputted to the inputs of the corrective unit **7.** The corrective unit **7** stores a succession of offset values corresponding to different values of temperature and is thus able to add a corrective offset assigned to the measured value of the temperature, to the measured value of the current of the measured line **6.** Thus, also in this case a more accurate value of the current of the measured line **6** is obtained.

In a third embodiment as illustrated in Fig. 4, the detecting means **50** comprise both a current a voltage sensor, e.g. a toroidal coil **9** through which a measured line phase **6** passes and a voltage divider **5.** The measuring signal output of the toroidal coil **9** is coupled to a current measuring signal input of the input circuit **4** the low voltage output **U** of the voltage divider **5** is coupled with a voltage measuring signal input of the input circuit **4** and the temperature signal output **T** of the thermometer **10** placed on or close to the toroidal coil **9** is coupled with the temperature signal input of the input circuit **4.** The current measuring signal output of the input circuit **4** is coupled with a current measuring signal input of a corrective unit **7** and the voltage measuring signal output of the input circuit **4** is coupled with a voltage measuring signal input of a corrective unit **7.** The temperature signal output of the input circuit **4** is then coupled with a temperature signal input of a corrective unit **7.** The current and voltage outputs of the corrective unit **7** are then coupled to a control unit **8.** In this way, both electrical parameters of the phase **6** are corrected at the same time.

The operation of current and voltage branches of the electronic measuring apparatus correcting voltage and current fluctuation work then in parallel as described in the first and second embodiments.

In all the above embodiments, in addition to the corrective coefficients for the temperature, the correction unit **7** can store sets of plurality of corrective coefficients. Each set corresponding to values of a different disturbing factor and can be applied at step **102** in alternative or in addition to the corrective coefficients which take into account the values of temperature. In particular, there could be suitable elements for direct information or measurement of these other disturbing factors, or the information may be derived as an outcome of electrical parameter(s) signal analysis, e.g. by means of Fourier transformation of current/voltage for frequency correction. For instance, the corrective unit **7** stores successions of offset values corresponding to different values of measured values of electric or magnetic fields internal or external to the apparatus itself, in particular in proximity of the detecting means **50.** In particular, one typical disturbing factor is due to the so called cross-talk effects. These effects are actually specific examples of electric or magnetic fields among different phases of a three phase equipment and depend on a value of the current flowing through the measured line **6,** on a value of the voltage of the measured line **6,** and on values of the current flowing through other phases of the measured line **6** and on a value of the voltage of the other phases of the measured line **6.** In this case, the apparatus according to the invention (illustrated for simplicity on in Fig. 2) preferably comprises at least a second instrument transformer **20,** e.g. a current sensor, operatively associated to a second phase **60** of the electrical conductor **6.** This second transformer **20,** which can be either a current and/or a voltage transformer, provides the electronic unit **2** with signals indicative of the values of at least one electrical parameter of the second phase **60.** In turn, the correction unit **7** comprises a plurality of pre-stored corrective coefficients corresponding to different values of crosstalk disturbances induced by the second phase **60** on the first phase. The same solutions apply with other phases where present. If desired to take into account interferences due to other electric and/or magnetic fields internal to the apparatus of the present invention, the correction unit **7** has a plurality of corrective coefficients corresponding to different values of such internal magnetic and/or electric fields. In particular, when a combination of current and voltage sensors are used, there could be an influence from an electric field onto the current sensor. In this case, the Information from the voltage measurement can be taken and current measurement may be corrected accordingly. This is valid vice versa for magnetic field influence.

Likewise, in order to take into account also possible magnetic and/or electric disturbing fields which are external to the apparatus of the present invention and are due for example to the presence of a device (not shown in the figs.)-such as switchgear, the electronic unit **2** is in operative communication with and receives information from another electronic unit **200.** This electronic unit **200** e.g. a relay, is operatively associated with this device positioned in proximity of the apparatus of the present invention and communicates to the electronic unit **2** information about the current and/or voltage of the neighbor device. From this information, values of such disturbing fields are calculated. In turn, the correction unit **7** comprises a plurality of corrective coefficients corresponding to different values of magnetic and/or electric fields external to the apparatus itself induced by the close electrical device.

Thus, if desired, it is possible to add a corrective offset assigned to the measured value of the electric or magnetic fields to the measured value of the voltage and/or current of the measured line phase **6** and outputs a more precise value. Similarly, in alternative embodiments the correction unit **7** can additionally comprise a plurality of pre-stored corrective coefficients corresponding to different values of current and/or voltage harmonics different from the rated frequency of the instrument transformers.

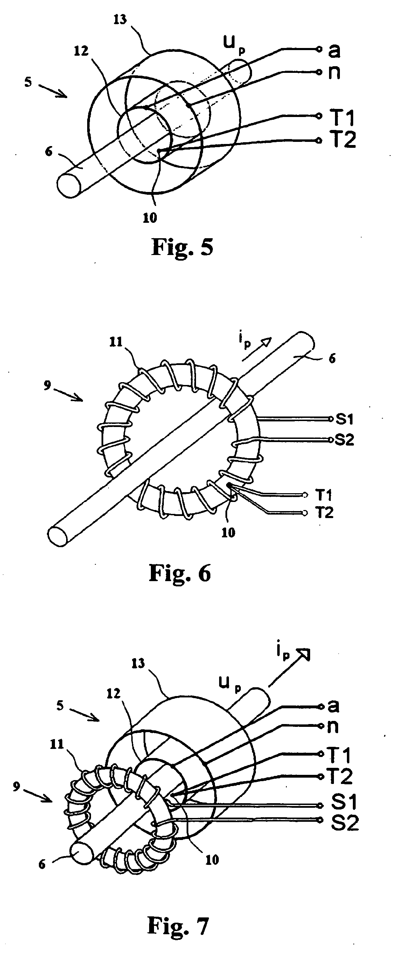

The voltage divider **5** is shown in more detail in Fig. 5. Around the measured line **6** there are two concentric shields **12** and **13,** and close to them there is again the thermometer **10.**

In operation the high voltage $\underline{u}_p$ of the measured line phase **6** is divided according to a ratio of capacitances between the measured line **6** and the first concentric shield **12** and between the first concentric shield **12** and the second concentric shield **13** that is earthed. The capacitances in a constant temperature do not fluctuate and the voltage between the first concentric shield **12** and the second concentric shield **13** is thus proportional to the high voltage $\underline{u}_p$ of the measured line **6,** with a possible offset caused by temperature fluctuation of the voltage divider **5** or other factors. Information on the instant temperature of the voltage divider **5** is provided by the thermometer **10** on the output terminals **T1** and **T2.** This information could be then used for a correction of the value of the high voltage $\underline{u}_p$ of the measured line **6.**

The toroidal coil **9** is in a preferred embodiment constructed as illustrated in Fig. 6. The measured line **6** passes through the toroidal coil **9.** The toroidal coil **9** is provided with a thermometer **10** and winding **11,** the thermometer **10** having output terminals **T1** and **T2,** winding **11** having output terminals **S1** and **S2.**

In operation the current $\underline{i}_p$, flowing through the measured line **6,** induces in the winding **11** a voltage that can be measured on output terminals **S1** and **S2.** An amplitude of the voltage measured on output terminals **S1** and **S2** is proportional to the current $\underline{i}_p$, flowing through the measured line **6,** with a possible offset caused by an instant temperature of the toroidal coil **9** or other factors. Information on the instant temperature of the toroidal coil **9** is provided by the thermometer **10** on the output terminals **T1** and **T2.** This information could be then used for a correction of value of the current $\underline{i}_p$, flowing through the measured line **6.**

Fig. 7 shows a combined transformer for measuring both high voltage $\underline{u}_p$ of the measured line $\underline{6}$ and the current $\underline{i}_p$, flowing through the measured line **6.** The toroidal coil $\underline{9}$ is seated next to the voltage divider **5.** The thermometer **10** is lodged between the first concentric shield **12** and the measured line **6.**

In operation the measurement of the current $\underline{i}_p$, flowing through the measured line **6** is conducted as described in connection with Fig. 6, while the measurement of the high voltage $\underline{u}_p$ of the measured line $\underline{6}$ is conducted as described in connection with Fig. 5. The output signal of the thermometer **10** is used for correction of measurement of both the high voltage $\underline{u}_p$ and of the current $\underline{i}_p$.

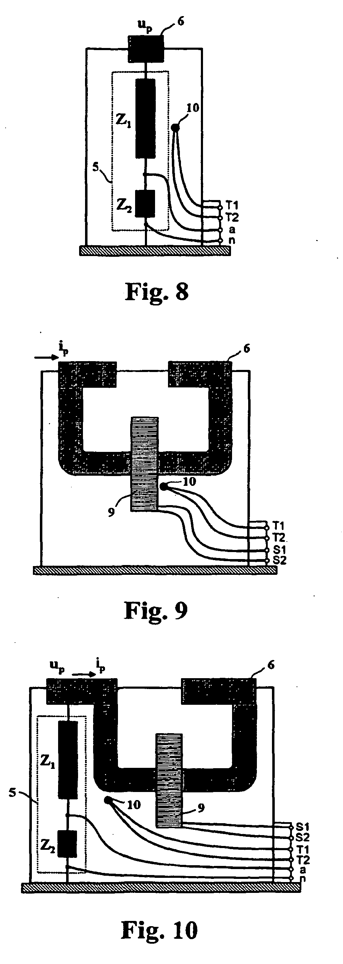

Fig. 8 shows schematically an electronic voltage transformer using the voltage divider **5,** that consists of two impedances $\underline{Z1}$ and $\underline{Z2}$ connected in series, where values of $\underline{Z1} >> \underline{Z2}$. The other terminal of the impedance $\underline{Z1}$ of the voltage divider **5** is connected to the measured line **6** and the other terminal of the impedance $\underline{Z2}$ is earthed. The voltage on the impedance $\underline{Z2}$ is then measured between terminals $\underline{a}$ and $\underline{n}$, as it is proportional to the high voltage $\underline{u}_p$ of the measured line **6.**

Fig. 9 shows schematically an electronic current transformer using the toroidal coil **9.** The signal induced in the toroidal coil **9** by the current $\underline{i}_p$, flowing through the measured line **6** is then measured between terminals **S1** and **S2.**

Fig. 10 shows a combined electronic transformer consisting of the voltage divider **5** and the toroidal coil **9.** This transformer measures both the high voltage $\underline{u}_p$ of the measured line **6** and the current $\underline{i}_p$, flowing through the measured line **6** as described in connection with Figs. 8 and 9.

It is to be understood that the description of the foregoing exemplary embodiment(s) is (are) intended to be only illustrative, rather than exhaustive, of the present invention. Those of ordinary skill will be able to make certain additions, deletions, and/or modifications to the embodiment(s) of the disclosed subject matter without departing from the invention or its scope, as defined by the appended claims.

**Claims**

1. An apparatus for measuring at least one electrical parameter of at least a first phase (6) of an electrical conductor, comprising:

   - an electronic unit (2);
   - detecting means (50) for providing said electronic unit (2) with signals indicative of values of said at least one electrical parameter and of values of at least one disturbing factor influencing said signals indicative of the values of said at least one electrical parameter, said electronic unit (2) calculating values of said at least one electrical parameter and of said at least one disturbing factor based on the provided signals; **characterized in that** it further comprises

- a correction unit (7) which is operatively coupled with said electronic unit (2) and has a plurality of pre-stored corrective coefficients corresponding to values of said at least one disturbing factor, wherein said corrective coefficients are applied to the calculated values of said at least one electrical parameter based on the calculated values of said at least one disturbing factor.

2. The apparatus according to claim 1, **characterized in that** said correction unit (7) has pres-stored sets of plurality of corrective coefficients each set corresponding to values of a different disturbing factor.

3. The apparatus according to claim 1, **characterized in that** said detecting means (50) comprise at least one electronic instrument transformer operatively associated to said first phase (6) of the electrical conductor.

4. The apparatus according to one or more of the previous claims, **characterized in that** said detecting means (50) comprise a first voltage divider (5) which provides said electronic unit (2) with signals indicative of the voltage of said first phase (6) of the electrical conductor.

5. The apparatus according to claim 3, **characterized in that** said detecting means (50) comprise at least a first toroidal coil (9) which provides said electronic unit (2) with signals indicative of the values of current flowing through said first phase (6) of the electrical conductor.

6. The apparatus according to one or more of the previous claims, **characterized in that** said detecting means (50) comprise at least one thermometer (10) which provides said electronic unit (2) with signals indicative of detected temperatures.

7. The apparatus according to one or more of the previous claims, **characterized in that** said correction unit (7) has a plurality of pre-stored corrective coefficients corresponding to different values of temperature.

8. An apparatus according to one or more of the previous claims, **characterized in that** it comprises at least a second instrument transformer (20) operatively associated to a second phase (60) of the electrical conductor which provides said electronic unit (2) with signals indicative of the values of at least one electrical parameter of said second phase (60), and said correction unit (7) comprises a plurality of pre-stored corrective coefficients corresponding to different values of crosstalk disturbances induced by said second phase (60) on the first phase (6).

9. An apparatus according to one or more of the previous claims, **characterized in that** said electronic unit (2) is in operative communication with and receives information from another electronic unit (200) operatively associated with an electrical device in proximity of the apparatus itself, and said correction unit (7) comprises a plurality of corrective coefficients corresponding to different values of magnetic and/or electric fields external to the apparatus itself induced by said electrical device.

10. An apparatus according to one or more of the previous claims, **characterized in that** said correction unit (7) comprises a plurality of corrective coefficients corresponding to different values of magnetic and/or electric fields internal to the apparatus itself.

11. An apparatus according to one or more of the previous claims, **characterized in that** said correction unit (7) comprises a plurality of corrective coefficients corresponding to different values of current and/or voltage harmonics different from rated frequencies.

12. A method for measuring at least one electrical parameter of at least a first phase of an electrical conductor, comprising the following steps:

- providing signals indicative of values of said at least one electrical parameter and of values of at least one disturbing factor influencing said signals indicative of the values of said at least one electrical parameter;
- calculating values of said at least one electrical parameter and of said at least one disturbing factor based on the provided signals; and

**characterized in that** it further comprises

- correcting the values calculated for said at least one electrical parameter by applying to the calculated values of said at least one electrical parameter pre-stored corrective coefficients corresponding to values calculated for said at least one disturbing factor.

13. The method as in claim 12, **characterized in that** it comprises:

- correcting the values calculated for said at least one electrical parameter by applying sets of pre-stored corrective coefficients, each set corresponding to values of a different disturbing factor.

**Patentansprüche**

1. Vorrichtung zur Messung mindestens eines elektrischen Parameters von mindestens der ersten Phase (6) eines elektrischen Leiters, umfassend:

   - ein elektronisches Steuergerät (2),
   - Erfassungsmittel (50) zur Versorgung des elektronischen Steuergeräts (2) mit Signalen, die die Werte des mindestens einen elektrischen Parameters sowie die Werte mindestens eines die obigen Werte des mindestens einen elektrischen Parameters angebenden Signale beeinflussenden Störfaktors angeben, wobei das elektronische Steuergerät (2) die Werte des mindestens einen elektrischen Parameters sowie des mindestens einen Störfaktors anhand der empfangenen Signale errechnet,

   **dadurch gekennzeichnet, dass**
   die Vorrichtung ferner eine Korrektionseinheit (7) umfasst, die funktionsmäßig mit dem elektronischen Steuergerät (2) verbunden ist und mehrere vorgespeicherte Korrektionskoeffizienten enthält, die den Werten des mindestens einen Störfaktors entsprechen, wobei die Korrektionskoeffizienten zur anhand der errechneten Werte des mindestens einen Störfaktors erfolgenden Korrektion der errechneten Werte des mindestens einen elektrischen Parameters angewendet werden.

2. Vorrichtung nach Anspruch 1, **dadurch gekennzeichnet, dass** die Korrektionseinheit (7) vorgespeicherte Sätze von Korrektionskoeffizienten etnhält, wobei jeder der Sätze den Werten eines anderen Störfaktors entspricht.

3. Vorrichtung nach Anspruch 1, **dadurch gekennzeichnet, dass** die Erfassungsmittel (50) mindestens einen elektronisch gesteuerten Messumformer umfassen, der funktionsmäßig mit der ersten Phase (6) des elektrischen Leiters gekoppelt ist.

4. Vorrichtung nach einem oder mehreren der vorhergehenden Ansprüche, **dadurch gekennzeichnet, dass** die Erfassungsmittel (50) einen ersten Spannungsteiler (5) umfassen, der das elektronische Steuergerät (2) mit Signalen versorgt, die den Wert der Spannung der ersten Phase (6) des elektrischen Leiters angeben.

5. Vorrichtung nach Anspruch 3, **dadurch gekennzeichnet, dass** die Erfassungsmittel (50) mindestens eine erste Toroidspule (9) umfassen, die das elektronische Steuergerät (2) mit Signalen versorgt, die die Werte des die erste Phase (6) des elektrischen Leiters durchströmenden Strom angeben.

6. Vorrichtung nach einem oder mehreren der vorhergehenden Ansprüche, **dadurch gekennzeichnet, dass** die Erfassungsmittel (50) mindestens einen Temperaturmessgerät (10) umfassen, der das elektronische Steuergerät (2) mit Signalen versorgt, die die Werte der erfassten Temperaturen angeben.

7. Vorrichtung nach einem oder mehreren der vorhergehenden Ansprüche, **dadurch gekennzeichnet, dass** die Korrektionseinheit (7) eine Vielzahl von vorgespeicherten Korrektionskoeffizienten enthält, die den unterschiedlichen Temperaturwerten entsprechen.

8. Vorrichtung nach einem oder mehreren der vorhergehenden Ansprüche, **dadurch gekennzeichnet, dass** sie mindestens einen zweiten elektronisch gesteuerten Messumformer umfasst, der funktionsmäßig mit der zweiten Phase (60) des elektrischen Leiters gekoppelt ist, um das elektronische Steuergerät (2) mit Signalen zu versorgen, die die Werte mindestens eines elektrischen Parameters der zweiten Phase (60) angeben, und dass die Korrektionseinheit (7) eine Vielzahl von vorgespeicherten Korrektionskoeffizienten enthält, die den unterschiedlichen Werten von störenden Übersprechkopplungen entsprechen, die von der zweiten Phase (60) induziert werden und auf die erste Phase (6) einwirken.

9. Vorrichtung nach einem oder mehreren der vorhergehenden Ansprüche, **dadurch gekennzeichnet, dass** das elektronische Steuergerät (2) funktionsmäßig mit einem anderen elektronischen Gerät (200) kommuniziert, von dem es Informationen empfängt, wobei das letztere Gerät funktionsmäßig mit einer nahe der eigentlichen Vorrichtung angeordneten elektrischen Anlage gekoppelt ist, und dass die Korrektionseinheit (7) eine Vielzahl von vorgespeicherten Korrektionskoeffizienten enthält, die den unterschiedlichen Werten von magnetischen und/oder elektrischen Feldern entsprechen, die von der obigen elektrischen Anlage außerhalb der eigentlichen Vorrichtung induziert werden.

10. Vorrichtung nach einem oder mehreren der vorhergehenden Ansprüche, **dadurch gekennzeichnet, dass** die Korrektionseinheit (7) eine Vielzahl von vorgespeicherten Korrektionskoeffizienten enthält, die den unterschiedlichen Werten von den innerhalb der eigentlichen Vorrichtung induzierten magnetischen und/oder elektrischen Feldern entsprechen.

11. Vorrichtung nach einem oder mehreren der vorhergehenden Ansprüche, **dadurch gekennzeichnet, dass** die Korrektionseinheit (7) eine Vielzahl von vorgespeicherten Korrektionskoeffizienten enthält, die den unterschiedlichen Werten von Strom- und/oder Spannungsoberschwingungen entsprechen, die von den Nennfrequenzen abweichend sind.

**12.** Verfahren zur Messung mindestens eines elektrischen Parameters von mindestens der ersten Phase eines elektrischen Leiters, das die folgenden Schritte umfasst:

 - die Erzeugung der Signale, die die Werte des mindestens einen elektrischen Parameters sowie die Werte mindestens eines die obigen Werte des mindestens einen elektrischen Parameters angebenden Signale beeinflussenden Störfaktors angeben;
 - die Errechnung der Werte des mindestens einen elektrischen Parameters sowie des mindestens einen Störfaktors anhand der erzeugten Signale,

 **dadurch gekennzeichnet, dass**
es ferner die Korrektion der errechneten Werte des mindestens einen elektrischen Parameters umfasst, die indem erfolgt, dass die errechneten Werte des mindestens einen elektrischen Parameters durch die Anwendung von vorgespeicherten Korrektionskoeffizienten korrigiert werden, die den errechneten Werten des mindestens einen Störfaktors entsprechen.

**13.** Verfahren nach Anspruch 12, **dadurch gekennzeichnet, dass** es ferner die Korrektion der errechneten Werte des mindestens einen elektrischen Parameters umfasst, die durch die Anwendung von den aus Korrektionskoeffizienten bestehenden Sätzen, wobei jeder der Sätze den Werten eines anderen Störfaktors entspricht.

**Revendications**

**1.** Appareil destiné à mesurer au moins un paramètre électrique d'au moins une première phase (6) d'un conducteur électrique, comprenant :

 - une unité électronique (2),
 - un moyen de détection (50) destiné à fournir à ladite unité électronique (2) des signaux indicateurs de valeurs dudit au moins un paramètre électrique et de valeurs au moins d'un facteur de perturbation influant sur lesdits signaux indicateurs des valeurs dudit au moins un paramètre électrique, ladite unité électronique (2) calculant les valeurs dudit au moins un paramètre électrique et dudit au moins un facteur de perturbation sur la base des signaux fournis, **caractérisé en ce qu'**il comprend en outre
 - une unité de correction (7) qui est couplée fonctionnellement à ladite unité électronique (2) et comporte une pluralité de coefficients correcteurs pré-mémorisés correspondant à des valeurs dudit au moins un facteur de perturbation, dans lequel lesdits coefficients correcteurs sont appliqués aux valeurs calculées dudit au moins un paramètre électrique sur la base des valeurs calculées dudit au moins un facteur de perturbation.

**2.** Appareil selon la revendication 1, **caractérisé en ce que** ladite unité de correction (7) comporte des ensembles pré-mémorisés d'une pluralité de coefficients correcteurs, chaque ensemble correspondant aux valeurs d'un facteur de perturbation différent.

**3.** Appareil selon la revendication 1, **caractérisé en ce que** ledit moyen de détection (50) comprend au moins un transformateur de mesure électronique associé fonctionnellement à ladite première phase (6) du conducteur électrique.

**4.** Appareil selon une ou plusieurs des revendications précédentes, **caractérisé en ce que** ledit moyen de détection (50) comprend un premier diviseur de tension (5) qui fournit à ladite unité électronique (2) des signaux indicateurs de la tension de ladite première phase (6) du conducteur électrique.

**5.** Appareil selon la revendication 3, **caractérisé en ce que** ledit moyen de détection (50) comprend au moins une première bobine torique (9) qui fournit à ladite unité électronique (2) des signaux indicateurs des valeurs du courant circulant à travers ladite première phase (6) du conducteur électrique.

**6.** Appareil selon une ou plusieurs des revendications précédentes, **caractérisé en ce que** ledit moyen de détection (50) comprend au moins un thermomètre (10) qui fournit à ladite unité électronique (2) des signaux indicateurs de températures détectées.

**7.** Appareil selon une ou plusieurs des revendications précédentes, **caractérisé en ce que** ladite unité de correction (7) comporte une pluralité de coefficients correcteurs pré-mémorisés correspondant aux différentes valeurs de températures.

**8.** Appareil selon une ou plusieurs des revendications précédentes, **caractérisé en ce qu'**il comprend au moins un deuxième transformateur de mesure (20) associé fonctionnellement à une deuxième phase (60) du conducteur électrique qui fournit à ladite unité électronique (2) des signaux indicateurs des valeurs du au moins un paramètre électrique de ladite deuxième phase (60), et ladite unité de correction (7) comprend une pluralité de coefficients correcteurs pré-mémorisés correspondant aux différentes valeurs de perturbations diaphoniques induites par ladite deuxième phase (60) sur la première phase (6).

**9.** Appareil selon une ou plusieurs des revendications précédentes, **caractérisé en ce que** ladite unité électronique (2) est en communication active avec une autre unité électronique (200) et reçoit des informations de celle-ci, associée activement à un dispositif électrique à proximité de l'appareil lui-même, et ladite unité de correction (7) comprend une pluralité de coefficients correcteurs correspondant à différentes valeurs de champs magnétiques et/ou électriques extérieurs à l'appareil lui-même induits par ledit dispositif électrique.

**10.** Appareil selon une ou plusieurs des revendications précédentes, **caractérisé en ce que** ladite unité de correction (7) comprend une pluralité de coefficients correcteurs correspondant à différentes valeurs de champs magnétiques et/ou électriques internes à l'appareil lui-même.

**11.** Appareil selon une ou plusieurs des revendications précédentes, **caractérisé en ce que** ladite unité de correction (7) comprend une pluralité de coefficients correcteurs correspondant à différentes valeurs d'harmoniques de courant et/ou de tension différentes des fréquences nominales.

**12.** Procédé destiné à mesurer au moins un paramètre électrique d'au moins une première phase d'un conducteur électrique, comprenant les étapes suivantes :

- la fourniture de signaux indicateurs de valeurs dudit au moins un paramètre électrique et de valeurs au moins d'un facteur de perturbation influant sur lesdits signaux indicateurs des valeurs dudit au moins un paramètre électrique,
- le calcul de valeurs dudit au moins un paramètre électrique et dudit au moins un facteur de perturbation sur la base des signaux fournis, et

**caractérisé en ce qu'**il comprend en outre

- la correction des valeurs calculées pour ledit au moins un paramètre électrique par l'application aux valeurs calculées dudit au moins un paramètre électrique de coefficients correcteurs pré-mémorisés correspondant aux valeurs calculées pour ledit au moins un facteur de perturbation.

**13.** Procédé selon la revendication 12, **caractérisé en ce qu'**il comprend :

- la correction des valeurs calculées pour ledit au moins un paramètre électrique par l'application d'ensembles de coefficients correcteurs pré-mémorisés, chaque ensemble correspondant à des valeurs d'un facteur de perturbation différent.

**Fig. 1**

**Fig. 2**

**Fig. 3**

**Fig. 4**

**Fig. 5**

**Fig. 6**

**Fig. 7**

**Fig. 8**

**Fig. 9**

**Fig. 10**

100 → Providing signals of electrcial parameter and of disturbing factor

101 → Calculating values of the electrical parameter and of the disturbing factor

102 → Applying corrective coefficients to the calculated values of the electrical parameter

# Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050156587 A, Yakymyshyn

- WO 02097454 A, Veselin Skendzic